# EUROPEAN PATENT SPECIFICATION

(11) **EP 2 071 348 B1**
(45) Date of publication and mention of the grant of the patent: **05.11.2014**
(21) Application number: 07713900.4
(22) Date of filing: 07.02.2007
(51) Int. Cl.: G01R 33/09, H01L 43/08

(54) **MAGNETIC DETECTOR**
MAGNETISCHER DETEKTOR
DÉTECTEUR MAGNÉTIQUE

(30) Priority: 30.08.2006 JP 2006234389
(43) Date of publication of application: 17.06.2009
(73) Proprietor: Alps Electric Co., Ltd., Ota-ku Tokyo 145-8501 (JP)
(72) Inventor: SASAKI, Yoshito, Tokyo 145-8501 (JP); KIKUIRI, Katsuya, Tokyo 145-8501 (JP); SATO, Kiyoshi, Tokyo 145-8501 (JP)
(74) Representative: Klunker . Schmitt-Nilson . Hirsch
(86) International application number: PCT/JP2007/052102
(87) International publication number: WO 2008/026327

(56) References cited:
- JP-A- 08 160 114
- JP-A- 59 159 565
- JP-A- H08 160 114
- JP-A- 2000 314 603
- US-A1- 2006 072 249

## Description

### Technical Field

The present invention relates to a magnetic detector including a magnetoresistance element using a magnetoresistance effect and, in particular, to a magnetic detector capable of reducing a consumption current.

### Background Art

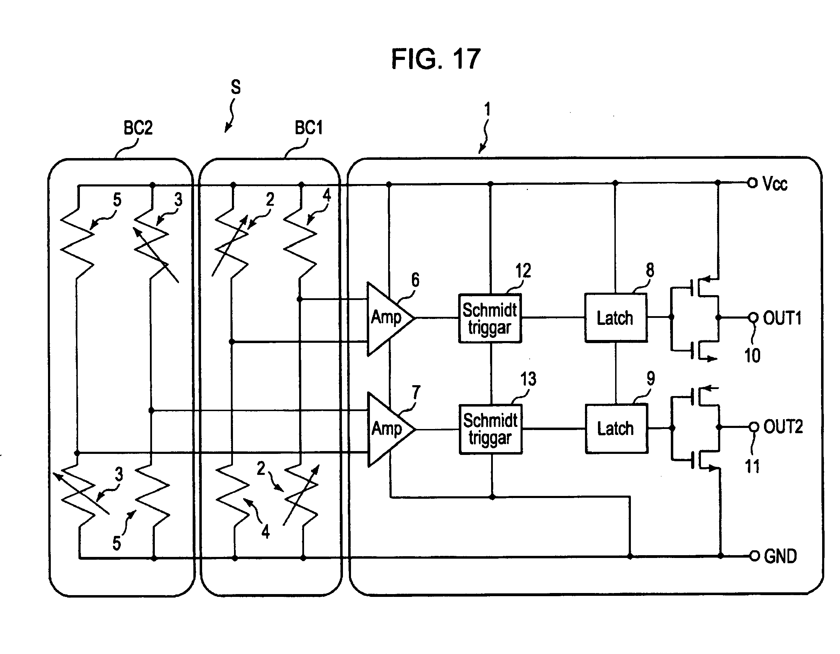

Fig. 17 is a circuit configuration diagram of an existing magnetic detector. The magnetic detector includes a sensor unit S and an integrated circuit (IC) 1. The magnetic detector shown in Fig. 17 is an NS detection sensor. The NS detection sensor detects both positive and negative magnetic fields. The sensor unit S includes a first bridge circuit BC1 and a second bridge circuit BC2. The first bridge circuit BC1 includes first magnetoresistance elements 2, such as GMR elements, that have a resistance value that changes in accordance with an external magnetic field in a positive direction. The second bridge circuit BC2 includes second magnetoresistance elements 3, such as GMR elements, that have a resistance value that changes in accordance with an external magnetic field in the negative direction. As used herein, the term "external magnetic field in a positive direction" refers to an external magnetic field in any one of directions. In the configuration shown in Fig. 20, the external magnetic field in the positive direction is an external magnetic field in a direction in which the resistance value of the first magnetoresistance element 2 changes, but the resistance value of the second magnetoresistance element 3 does not change (i.e., the first magnetoresistance element 2 functions as a fixed resistor). The term "external magnetic field in a negative direction" refers to an external magnetic field in a direction opposite to the positive direction. In the configuration shown in Fig. 20, the external magnetic field in the negative direction is an external magnetic field in a direction in which the resistance value of the second magnetoresistance element 3 changes, but the resistance value of the first magnetoresistance element 2 does not change (i.e., the second magnetoresistance element 3 functions as a fixed resistor).

As shown in Fig. 17, each of the first magnetoresistance elements 2 and a corresponding fixed resistance element 4 form a series circuit. The two series circuits are connected in parallel so as to form the first bridge circuit BC1. Each of output retrieving units of the two series circuits of the first bridge circuit BC1 is connected to a first differential amplifier 6. In addition, as shown in Fig. 17, each of the second magnetoresistance element 3 and a corresponding fixed resistance element 5 form a series circuit. The two series circuits are connected in parallel so as to form the second bridge circuit BC2. Each of output retrieving units of the two series circuits of the second bridge circuit BC2 is connected to a second differential amplifier 7.

The integrated circuit 1 includes Schmidt trigger comparators 12 and 13 and latch circuits 8 and 9 in addition to the differential amplifiers 6 and 7. An external magnetic field detection signal is retrieved from external output terminals 10 and 11.

In the magnetic detector shown in Fig. 17, when an external magnetic field in the positive direction acts on the magnetic detector, the resistance value of the first magnetoresistance element 2 of the first bridge circuit BC1 varies. Accordingly, the output of the first bridge circuit BC1 is differential-amplified by the first differential amplifier 6. Thereafter, a detection signal is generated on the basis of the differential-amplified output. Subsequently, the detection signal is output from the external output terminal 10. In contrast, when an external magnetic field in the negative direction acts on the magnetic detector, the resistance value of the second magnetoresistance element 3 of the second bridge circuit BC2 varies. Accordingly, the output of the second bridge circuit BC2 is differential-amplified by the second differential amplifier 7. Thereafter, a detection signal is generated on the basis of the differential-amplified output. Subsequently, the detection signal is output from the external output terminal 11.

As described above, the magnetic detector shown in Fig. 17 functions as an NS detection sensor that can detect magnetic fields in the positive direction and the negative direction.
[Patent Document 1] Japanese Unexamined Patent Application Publication No. 2004-77374
[Patent Document 2] Japanese Unexamined Patent Application Publication No. 2004-180286
[Patent Document 3] Japanese Unexamined Patent Application Publication No. 2005-214900
[Patent Document 4] Japanese Unexamined Patent Application Publication No. 2003-14833
[Patent Document 5] Japanese Unexamined Patent Application Publication No. 2003-14834
[Patent Document 6] Japanese Unexamined Patent Application Publication No. 2003-121268
[Patent Document 7] Japanese Unexamined Patent Application Publication No. 2004-304052

According to JP H08 160 114 A magneto-resistive elements are arranged so that their magnetic field detecting directions can intersect each other at a right angle and an operational amplifier circuit outputs a potential difference generated by the variation of the resistance values of the elements. Since the resistance values of resistors are set at the same value, the resistors operate as a current mirror circuit. When a magnetic field is impressed upon a magnetic sensor, a potential difference is generated between the collector-side potentials of transistors, because the resistance value of one of the elements drops. The position of an object is detected based on the potential difference. In addition, since the resistance values of the resistors are set at larger values than those of the elements, the current consumption of the sensor varies depending upon the resistance values of the resistors. The pattern areas of the elements can be reduced, because the resistance values of the element are not required to be increased for reducing the current consumption.

US 2006/072249 A1 discloses a magnetic sensor including a single substrate, a conventional GMR element formed of a spin-valve film including a single-layer-pinned fixed magnetization layer, and a SAF element formed of a synthetic spin-valve film including a plural-layer-pinned fixed magnetization layer. When the spin-valve film intended to act as the conventional GMR element and the synthetic spin-valve film intended to act as the SAF element are subjected to the application of a magnetic field oriented in a single direction at a high temperature, they become giant magnetoresistive elements whose magnetic-field-detecting directions are antiparallel to each other. Since films intended to act as the conventional GMR element and the SAF element can be disposed close to each other, the magnetic sensor which has giant magnetoresistive elements whose magnetic-field-detecting directions are antiparallel to each other can be small.

### Disclosure of Invention

### Problems to be Solved by the Invention

However, as shown in Fig. 17, in the configuration of existing magnetic detectors, in order to appropriately control the potential of each of the output retrieving units so that the potential is equal to a central potential, the fixed resistance elements 4 and 5 series-connected to the magnetoresistance elements 2 and 3 need to be disposed so as to be close to the magnetoresistance elements 2 and 3, respectively.

Since the element resistance of each of the magnetoresistance elements 2 and 3 is several kΩ, the element resistance of each of the fixed resistance elements 4 and 5 also needs to be controlled so as to be several kΩ.

As described above, in the existing configuration, the element resistance of each of the fixed resistance elements 4 and 5 cannot be increased independently from the element resistance of each of the magnetoresistance elements 2 and 3. In particular, as the size of the magnetic detector is decreased, the space provided for forming each of the elements of the sensor unit S is decreased. Accordingly, the element resistance cannot be sufficiently increased, and therefore, a consumption current disadvantageously increases.

In particular, in NS detection sensors like the magnetic detector shown in Fig. 17, a large number of elements are required for forming the sensor unit S. That is, the NS detection sensor requires two bridge circuits BC1 and BC2, and the number of the elements is eight in total. Accordingly, the space for forming each of the elements is further reduced. Consequently, according to the existing configuration of the elements of the sensor unit S, the element resistance cannot be sufficiently increased.

Accordingly, the present invention provides a magnetic detector that solves the above-described problem and, in particular, a magnetic detector capable of reducing a consumption current, as compared with existing magnetic detectors.

### Means for Solving the Problems

According to the present invention, a magnetic detector includes a bridge circuit including a first series circuit connected to a second series circuit in parallel. The first series circuit includes a plurality of resistance elements, and at least one of the resistance elements is a magnetoresistance element having an electric resistance that changes in accordance with an external magnetic field using a magnetoresistance effect. The second series circuit includes a plurality of resistance elements, and all of the resistance elements are fixed resistance elements having an electric resistance that does not change in accordance with an external magnetic field. An element resistance of the fixed resistance element included in the second series circuit is greater than an element resistance of the resistance elements included in the first series circuit.

In the above-described configuration of the elements of the bridge circuit, a magnetoresistance element is not connected to the second series circuit. The second series circuit is formed from only fixed resistance elements. Accordingly, unlike a fixed resistance element that is connected to a magnetoresistance element in series, when the fixed resistance element is produced, the element resistance of the fixed resistance element need not be matched to the element resistance of a magnetoresistance element. That is, the material of the fixed resistance element can be selected from among a wider variety of materials, as compared with those of existing fixed resistance elements. Thus, the potential of an output retrieving unit can be controlled so as to be a central potential. In addition, the element resistance of the fixed resistance elements included in the second series circuit can be increased so as to be greater than the element resistance of the resistance elements included in the first series circuit. As a result, a consumption current can be reduced while maintaining a high detection accuracy.

In addition, according to the present invention, it is desirable that the magnetic detector further includes a sensor unit disposed on a substrate, where the sensor unit includes the first series circuit, and an integrated circuit disposed on the substrate and connected to the sensor unit, where the integrated circuit outputs a magnetic field detection signal, and that the second series circuit is incorporated in the integrated circuit. In this way, the space for forming the sensor unit can be increased. Therefore, greater flexibility in designing a magnetic detector can be achieved. In addition, the element resistance of the resistance element included in the first series circuit can be increased. Accordingly, the element resistance of each of the resistance elements included in the sensor unit can be increased, as compared with those of existing magnetic detectors. Consequently, a consumption current can be more effectively reduced. Furthermore, by incorporating the second series circuit into the integrated circuit, the fixed resistance elements included in the second series circuit can be formed using a high-resistance material having a high sheet resistance, like the other resistance elements provided in the integrated circuit.

In addition, according to the present invention, it is desirable that the magnetic detector further includes a third series circuit including a plurality of resistance elements. The magnetoresistance element included in the first series circuit has an electric resistance that changes in accordance with variation in the magnitude of an external magnetic field in a certain direction using a magnetoresistance effect, and at least one of the plurality of resistance elements of the third series circuit is a magnetoresistance element having an electric resistance that changes in accordance with an external magnetic field in a direction opposite to the certain direction. The first series circuit is connected to the second series circuit in parallel so as to form the first bridge circuit that detects the external magnetic field in the certain direction, and the second series circuit is connected to the third series circuit in parallel so as to form a second bridge circuit that detects the external magnetic field in the direction opposite to the certain direction. In this way, the magnetic detector can function as an NS detection sensor. In addition, since the third series circuit is used as a common circuit of the first bridge circuit and the second bridge circuit, the number of elements required for forming two bridge circuits can be reduced. Consequently, since the space for forming each of the resistance elements can be increased, greater flexibility in designing a magnetic detector can be achieved. In addition, the element resistances of the resistance elements can be increased. Consequently, a consumption current can be effectively reduced.

According to the present invention, since a plurality of resistance elements included in the third series circuit are formed from the same material layers, the element resistances of the resistance elements can be the same. Accordingly, the potential of the output retrieving unit can be maintained at the central potential. Moreover, the differences among the temperature coefficients (TCRs) can be reduced. As a result, variation in the central potential in accordance with a temperature change can be reduced, and therefore, the operational stability can be advantageously improved.

In addition, according to the present invention, it is desirable that the magnetic detector further includes a sensor unit disposed on a substrate, where the sensor unit includes the first series circuit and the third series circuit, and an integrated circuit disposed on the substrate, where the integrated circuit is connected to the sensor unit and the integrated circuit outputs a magnetic field detection signal, and that the second series circuit is incorporated in the integrated circuit. In this way, a space for forming the sensor unit can be increased. Therefore, greater flexibility in designing a magnetic detector can be achieved. In addition, the element resistances of the resistance elements included in the first series circuit and the third series circuit can be increased. Accordingly, the element resistance of each of the resistance elements included in the sensor unit can be increased, as compared with those of existing magnetic detectors. Consequently, a consumption current can be more effectively reduced. Furthermore, by incorporating the second series circuit into the integrated circuit, the fixed resistance elements included in the second series circuit can be formed using a high-resistance material having a high sheet resistance, like the other resistance elements provided in the integrated circuit.

Furthermore, according to the present invention, it is more desirable that the integrated circuit be formed on the substrate, and the sensor unit be formed on the integrated circuit with an insulating layer therebetween. Such a layer structure can increase a space for forming the sensor unit and the flexibility in designing the magnetic detector. In addition, the element resistance of each of the resistance elements included in the sensor unit can be increased. Consequently, a consumption current can be effectively reduced.

Still furthermore, according to the present invention, the plurality of resistance elements included in the first series circuit can be formed from the same material layers. Accordingly, the potential of the output retrieving unit can be appropriately controlled so as to be the central potential. Moreover, the differences among the temperature coefficients (TCRs) can be reduced. As a result, variation in the central potential in accordance with a temperature change can be reduced, and therefore, the operational stability can be advantageously improved.

Yet still furthermore, according to the present invention, the plurality of fixed resistance elements included in the second series circuit can be formed from the same material layers. Accordingly, the potential of the output retrieving unit can be appropriately controlled so as to be a central potential. Moreover, the differences among the temperature coefficients (TCRs) can be reduced. As a result, variation in the central potential in accordance with a temperature change can be reduced, and therefore, the operational stability can be advantageously improved.

According to the present invention, it is more effective if the fixed resistance elements are formed of silicon (Si). In particular, by incorporating the fixed resistance elements into the integrated circuit, the fixed resistance elements can be formed of silicon, like the other resistance elements formed in the integrated circuit. In particular, by forming the fixed resistance elements using silicon, the element resistance can be increased to several tens of kΩ. This element resistance is several tens of times higher than that of the fixed resistance elements used in the existing structure illustrated in Fig. 17. Therefore, a consumption current can be more effectively reduced.

### Advantages

The present invention can effectively reduce a consumption current, as compared with existing magnetic detectors.

### Best Mode for Carrying Out the Invention

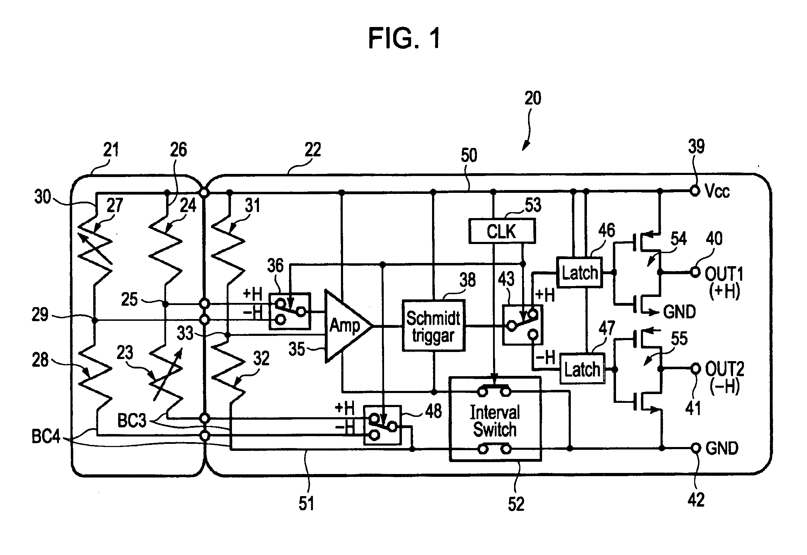

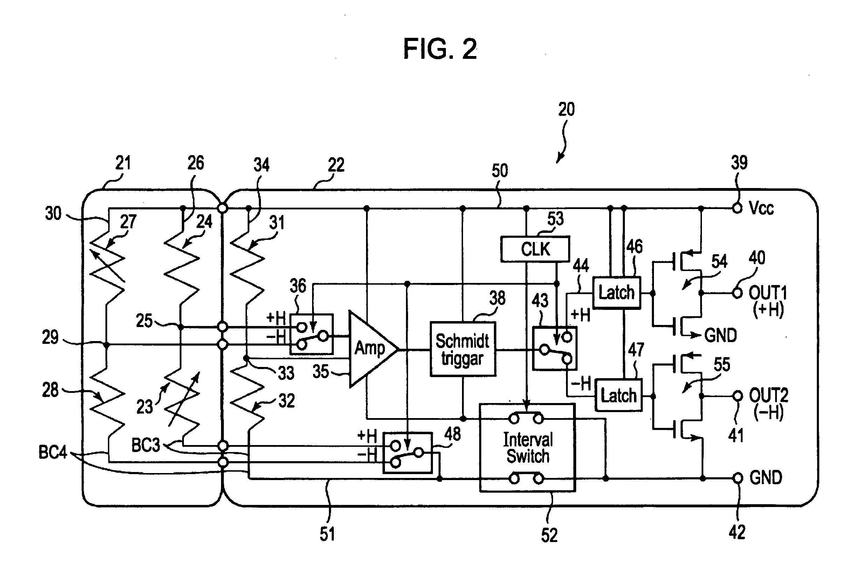

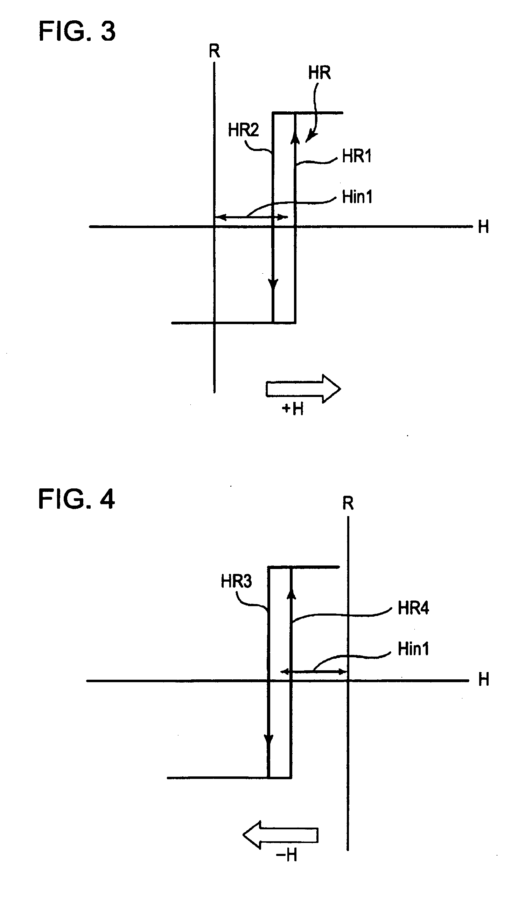

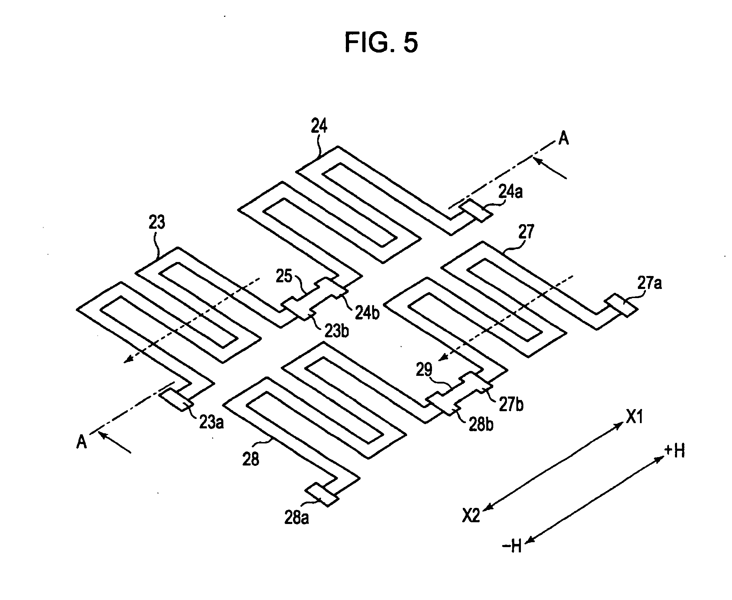

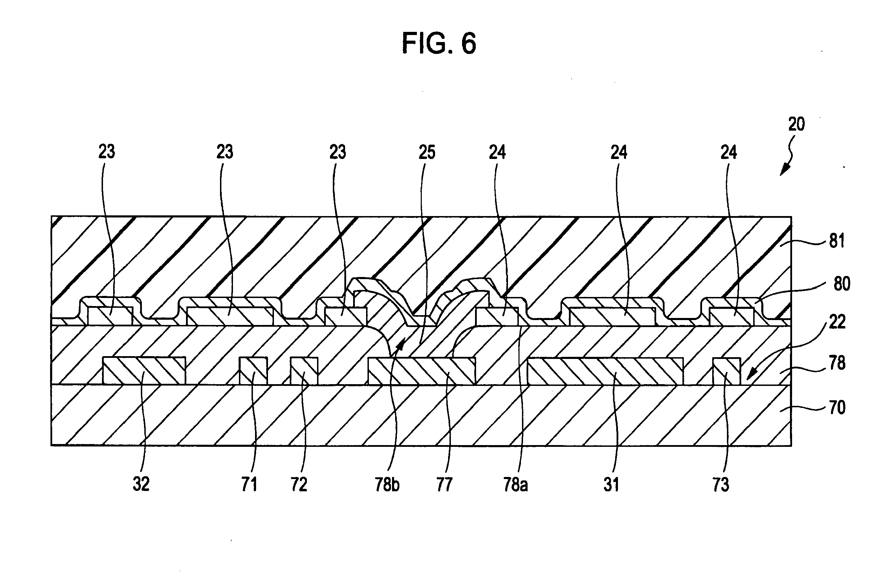

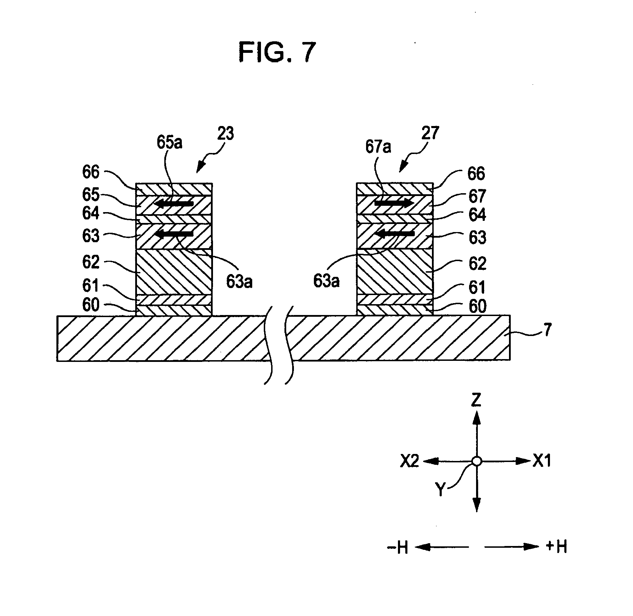

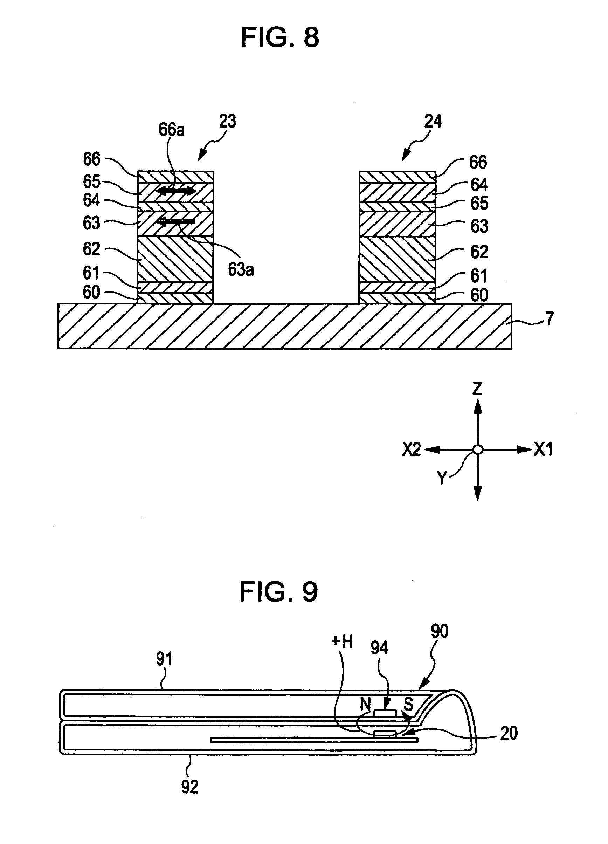

Figs. 1 and 2 are circuit diagrams of a magnetic detector 20 according to the present embodiment. Fig. 3 is a graph (an R-H curve) illustrating a hysteresis characteristic of a first magnetoresistance element. Fig. 4 is a graph (an R-H curve) illustrating hysteresis characteristics of a second magnetoresistance element. Fig. 5 is a partial enlarged perspective view illustrating the shape of a resistance element of a sensor unit of the magnetic detector 20 according to the present embodiment. Fig. 6 is a partial cross-sectional view of the magnetic detector taken along a line A-A shown in Fig. 5 in a thickness direction and viewed in a direction indicated by an arrow. Fig. 7 is a partial cross-sectional view illustrating the layer structure of the first magnetoresistance element and the second magnetoresistance element. Fig. 8 is a partial cross-sectional view mainly illustrating the layer structure of a fixed resistance element. Figs. 9 to 16 are schematic illustrations and partial plan views of a flip cell phone including the magnetic detector according to the present embodiment (e.g., Figs. 9 to 16 illustrate an example of usage of the magnetic detector according to the present embodiment).

As shown in Fig. 1, the magnetic detector 20 includes a sensor unit 21 and an integrated circuit (IC) 22.

The sensor unit 21 includes a first series circuit 26 and a third series circuit 30. The first series circuit 26 includes a first resistance element (a first magnetoresistance element) 23 and a second resistance element 24 (a fixed resistance element in the present embodiment) connected in series via a first output retrieving unit (a connection unit) 25. The third series circuit 30 includes a fifth resistance element (a second magnetoresistance element) 27 and a sixth resistance element 28 (a fixed resistance element in the present embodiment) connected in series via a third output retrieving unit (a connection unit) 29.

The integrated circuit 22 includes a second series circuit 34. The second series circuit 34 includes a third resistance element (a fixed resistance element) 31 and a fourth resistance element (a fixed resistance element) 32 connected in series via a second output retrieving unit (a connection unit) 33.

As noted above, the resistance elements are denoted as the "first to sixth resistance elements". Hereinafter, in general, each of the resistance elements is denoted as a "magnetoresistance element" or a "fixed resistance element". However, if distinction between "magnetoresistance element" and "fixed resistance element" is unnecessary, then the resistance element is simply denoted as a "resistance element".

The second series circuit 34 serving as a common circuit and the first series circuit 26 form a bridge circuit. In addition, the second series circuit 34 and the third series circuit 30 form a bridge circuit. Hereinafter, the bridge circuit formed by connecting the first series circuit 26 to the second series circuit 34 in parallel is referred to as a "first bridge circuit BC3", and the bridge circuit formed by connecting the third series circuit 30 to the second series circuit 34 in parallel is referred to as a "second bridge circuit BC4".

As shown in Fig. 1, in the first bridge circuit BC3, the first resistance element 23 is connected to the fourth resistance element 32 in parallel, and the second resistance element 24 is connected to the third resistance element 31 in parallel. In the second bridge circuit BC4, the fifth resistance element 27 is connected to the third resistance element 31 in parallel, and the sixth resistance element 28 is connected to the fourth resistance element 32 in parallel.

As shown in Fig. 1, the integrated circuit 22 includes an input terminal (a power supply) 39, a ground terminal 42, and two external output terminals 40 and 41. The input terminal 39, the ground terminal 42, and the external output terminals 40 and 41 are electrically connected to corresponding terminal units of the device (not shown) by wire bonding or die bonding.

A signal line 50 is connected to the input terminal 39. A signal line 51 is connected to the ground terminal 42. The signal line 50 is further connected to electrodes provided on one side of the first series circuit 26, the third series circuit 30, and the second series circuit 34. The signal line 51 is further connected to electrodes provided on the other side of the first series circuit 26, the third series circuit 30, and the second series circuit 34.

As shown in Fig. 1, the integrated circuit 22 includes a differential amplifier 35. The second output retrieving unit 33 of the second series circuit 34 is connected to one of a + input unit and a - input unit of the differential amplifier 35.

The first output retrieving unit 25 of the first series circuit 26 and the third output retrieving unit 29 of the third series circuit 30 are connected to an input unit of a first switch circuit (a first connection switching unit) 36. An output unit of the first switch circuit 36 is connected to one of the + input unit and the - input unit of the differential amplifier 35 (the input unit disposed on the side to which the second output retrieving unit 33 is not connected).

As shown in Fig. 1, the output unit of the differential amplifier 35 is connected to a Schmidt trigger comparator 38. An output unit of the Schmidt trigger comparator 38 is connected to an input unit of a second switch circuit (a second connection switching unit) 43. Two output units of the second switch circuit 43 are connected to the first external output terminal 40 and the second external output terminal 41 via two latch circuits 46 and 47 and two FET circuits 54 and 55, respectively. Note that the FET circuits 54 and 55 form a logic circuit.

Furthermore, as shown in Fig. 1, the integrated circuit 22 includes a third switch circuit 48. An output unit of the third switch circuit 48 is connected to the signal line 51 connected to the ground terminal 42. One end of the first series circuit 26 and one end of the third series circuit 30 are connected to an input unit of the third switch circuit 48.

Still furthermore, as shown in Fig. 1, the integrated circuit 22 includes an interval switch circuit 52 and a clock circuit 53. When a switch of the interval switch circuit 52 is turned off, supply of power to the integrated circuit 22 is stopped. On and off of the switch of the interval switch circuit 52 is synchronized with a clock signal output from the clock circuit 53. The interval switch circuit 52 has a power saving function in which power is intermittently supplied to the integrated circuit 22.

The clock signal is also output from the clock circuit 53 to the first switch circuit 36, the second switch circuit 43, and the third switch circuit 48. Upon receiving the clock signal, the first switch circuit 36, the second switch circuit 43, and the third switch circuit 48 divide the clock signal so as to perform a switching operation at significantly short intervals. For example, when one pulse of the clock signal is several tens of msec, the switching operation is performed at several tens of µ msec intervals.

The first magnetoresistance element 23 is a magnetoresistance element having a magnetoresistance effect in accordance with a change in the magnitude of an external magnetic field (+H) in the positive direction. In contrast, the second magnetoresistance element 27 is a magnetoresistance element having a magnetoresistance effect in accordance with a change in the magnitude of an external magnetic field (-H) in the negative direction opposite to the positive direction.

Here, the external magnetic field (+H) in the positive direction represents an external magnetic field in a certain direction. According to the present embodiment, the certain direction is the X1 direction shown in the drawing. The external magnetic field (-H) in the negative direction represents an external magnetic field in a direction opposite the positive direction. The negative direction is the X2 direction in the drawing.

The layer structures and the hysteresis characteristics of the first magnetoresistance element 23 and the second magnetoresistance element 27 are described in detail below.

As shown in Fig. 7, each of the first magnetoresistance element 23 and the second magnetoresistance element 2 includes, from the bottom, the following layers: an underlayer 60, a seed layer 61, an antiferromagnetic layer 62, a fixed magnetic layer 63, a nonmagnetic interlayer 64, a free magnetic layer 65 or 67 (a reference numeral "37" is used for a free magnetic layer of the second magnetoresistance element 27), and a protective layer 66. The underlayer 60 is formed of, for example, one or two of the following nonmagnetic element materials: Ta, Hf, Nb, Zr, Ti, Mo, and W. The seed layer 61 is formed of, for example, NiFeCr or Cr. The antiferromagnetic layer 62 is formed of an antiferromagnetic material including elements α (where α is one or more of Pt, Pd, Ir, Rh, Ru, and Os) and Mn. Alternatively, the antiferromagnetic layer 62 is formed of the element α, an element α' (where α' is one or more of Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb, and a rare-earth element), and Mn. For example, the antiferromagnetic layer 62 is formed of IrMn or PtMn. Each of the fixed magnetic layer 63, the free magnetic layer 65, and the free magnetic layer 67 is formed of a magnetic material, such as a CoFe alloy, an NiFe alloy, or a CoFeNi alloy. The nonmagnetic interlayer 64 is formed of, for example, Cu. The protective layer 66 is formed of, for example, Ta. The fixed magnetic layer 63, the free magnetic layer 65, and the free magnetic layer 67 may have a layered ferri structure (a layer structure including a magnetic layer, a nonmagnetic layer, and a magnetic layer stacked in this order, and the magnetization directions of the two magnetic layers sandwiching the nonmagnetic layer are antiparallel). Alternatively, the fixed magnetic layer 63, the free magnetic layer 65, and the free magnetic layer 67 may have a layer structure having a plurality of magnetic layers of different materials stacked therein.

In the first magnetoresistance element 23 and the second magnetoresistance element 27, the antiferromagnetic layer 62 is in contact with the fixed magnetic layer 63. Accordingly, by heat processing the first magnetoresistance element 23 and the second magnetoresistance element 27 in a magnetic field, an exchange coupling field (Hex) is generated on the interface between the antiferromagnetic layer 62 and the fixed magnetic layer 63 and, therefore, the magnetization direction of the fixed magnetic layer 63 is fixed to one direction. In Figs. 5 and 7, a magnetization direction 63a of the fixed magnetic layer 63 is indicated by an arrow. In each of the first magnetoresistance element 23 and the second magnetoresistance element 27, the magnetization direction 63a of the fixed magnetic layer 63 is the X1 direction (the positive direction) in the drawing.

In contrast, the magnetization directions of the free magnetic layers 65 and 67 are different between the first magnetoresistance element 23 and the second magnetoresistance element 27. As shown in Fig. 7, in the first magnetoresistance element 23, a magnetization direction 65a of the free magnetic layer 65 is the X2 direction (the negative direction) in the drawing. This direction is the same as the magnetization direction 63a of the fixed magnetic layer 63. However, in the second magnetoresistance element 27, a magnetization direction 67a of the free magnetic layer 67 is the X1 direction (the positive direction) in the drawing. This direction is antiparallel to the magnetization direction 63a of the fixed magnetic layer 63.

When an external magnetic field (+H) in the positive direction acts on the second magnetoresistance element 27 and the first magnetoresistance element 23, the magnetization 67a of the free magnetic layer 67 of the second magnetoresistance element 27 does not vary. However, the magnetization 65a of the free magnetic layer 65 of the first magnetoresistance element 23 varies. As a result, the resistance value of the first magnetoresistance element 23 varies. Fig. 3 is the R-H curve illustrating the hysteresis characteristic of the first magnetoresistance element 23. Note that, although the ordinate of the graph represents the resistance value R, a resistance value change ratio (%) may be used for the ordinate. As shown in Fig. 3, as the external magnetic field in the positive direction is gradually increased from a non-magnetic field (zero), a state of equilibrium between the magnetization 65a of the free magnetic layer 65 and the magnetization 63a of the fixed magnetic layer 63 cannot be maintained and reaches an antiparallel state. Accordingly, the resistance value R of the first magnetoresistance element 23 gradually increases along the curve HR1. In contrast, as the external magnetic field (+H) in the positive direction is gradually decreased to zero, the resistance value R is gradually decreased along the curve HR2.

Thus, the first magnetoresistance element 23 forms a hysteresis loop HR surrounded by the curves HR1 and HR2 in accordance with a variation in the magnitude of the external magnetic field (+H) in the positive direction. A "midpoint" of the hysteresis loop HR is defined by a central value between a maximum resistance and a minimum resistance of the first magnetoresistance element 23 and a central value of the width of the hysteresis loop HR. The magnitude of a first interlayer coupling magnetic field Hin1 is determined by the magnitude of the magnetic field in the range of the center point of the hysteresis loop HR to a line of an external magnetic field H = 0 (Oe). As can be seen from Fig. 3, in the first magnetoresistance element 23, the first interlayer coupling magnetic field Hin1 is shifted toward the positive magnetic field direction.

In contrast, when an external magnetic field (-H) in the negative direction acts on the first magnetoresistance element 23 and the second magnetoresistance element 27, the magnetization 65a of the free magnetic layer 65 of the first magneto-resistance element 23 does not vary. However, the magnetization 67a of the free magnetic layer 67 of the second magnetoresistance element 27 varies, and therefore, the resistance value of the second magnetoresistance element 27 varies.

Fig. 4 shows an R-H curve illustrating the hysteresis characteristic of the second magnetoresistance element 27. As shown in Fig. 4, as the external magnetic field is gradually increased from the non-magnetic field state (zero) in the negative direction, the antiparallel state between the magnetization 67a of the free magnetic layer 67 and the magnetization 63a of the fixed magnetic layer 63 cannot be maintained and is close to a parallel state. Consequently, the resistance value R of the second magnetoresistance element 27 is gradually decreased along a curve HR3. In contrast, as the external magnetic field (-H) in the negative direction is gradually changed to zero, the resistance value R of the second magnetoresistance element 27 gradually increases along a curve HR4.

In this way, the second magnetoresistance element 27 forms a hysteresis loop HR surrounded by the curves HR3 and HR4 in accordance with a variation in the magnitude of the external magnetic field (-H) in the negative direction. A "midpoint" of the hysteresis loop HR is defined by a central value between a maximum resistance and a minimum resistance of the second magnetoresistance element 27 and a central value of the width of the hysteresis loop HR. The magnitude of a second interlayer coupling magnetic field Hin2 is determined by the magnitude of the magnetic field in the range of the center point of the hysteresis loop HR to a line of an external magnetic field H = 0 (Oc). As can be seen from Fig. 4, in the second magnetoresistance element 27, the second interlayer coupling magnetic field Hin2 is shifted toward the negative magnetic field direction.

As described above, according to the present embodiment, the first interlayer coupling magnetic field Hin1 of the first magnetoresistance element 23 is shifted towards the positive magnetic field direction. In contrast, the second interlayer coupling magnetic field Hin2 of the second magnetoresistance element 27 is shifted towards the negative magnetic field direction.

For example, by appropriately controlling a gas flow rate (a gas pressure) or electric power at the time of performing a plasma treatment (PT) on the surface of the nonmagnetic interlayer 64, the interlayer coupling magnetic fields Hin1 and Hin2 having opposite signs illustrated in Figs. 3 and 4 can be obtained. It is a well-recognized phenomenon that an interlayer coupling magnetic field Hin varies in accordance with the gas flow rate (a gas pressure) or electric power. As the gas flow rate (a gas pressure) or electric power is increased, the interlayer coupling magnetic field Hin can be changed from a positive value to a negative value. In addition, the magnitude of the interlayer coupling magnetic field Hin varies in accordance with the thickness of the nonmagnetic interlayer 64. Alternatively, when the antiferromagnetic layer, the fixed magnetic layer, the nonmagnetic intermediate layer, and the free magnetic layer are stacked from the bottom in this order, the magnitude of the interlayer coupling magnetic field Hin can be controlled by changing the thickness of the antiferromagnetic layer.

In the first magneto-resistance element 23, the first interlayer coupling magnetic field Hin1 is positive. In such a case, mutual interaction occurs between the fixed magnetic layer 63 and the free magnetic layer 65 so that the magnetization of the fixed magnetic layer 63 is parallel to the magnetization of the free magnetic layer 65. In addition, in the second magneto-resistance element 27, the second interlayer coupling magnetic field Hin2 is negative. In such a case, the mutual interaction is induced between the fixed magnetic layer 63 and the free magnetic layer 67 so that the magnetization of the fixed magnetic layer 63 is antiparallel to the magnetization of the free magnetic layer 67. By generating exchanging coupling magnetic fields (Hex) in the same direction between the antiferromagnetic layer 62 and the fixed magnetic layer 63 of each of the magnetoresistance elements 23 and 27 using heat treatment in the magnetic field, the magnetization 63a of the fixed magnetic layer 63 of each of the magnetoresistance elements 23 and 27 can be fixed in the same direction. Furthermore, since the above-mentioned mutual interaction occurs between the fixed magnetic layer 63 and each of the free magnetic layers 65 and 67, the state of magnetization as shown in Fig. 7 appears.

While the above description has been made with reference to the first magnetoresistance element 23 and the second magnetoresistance element 27 that employ a giant magnetoresistance effect (a GMR effect), an AMR element employing an anisotropic magnetoresistance effect or a TMR element employing a tunnel magnetoresistance effect (TMR) may be used in place of a GMR element.

On the other hand, the second resistance element 24 series-connected to the first magnetoresistance element 23 has material layers the same as those of the first magnetoresistance element 23. However, the order in which the material layers are stacked is different from that of the first magnetoresistance element 23. That is, as shown in Fig. 8, the fixed resistance element 24 includes, from the bottom, the following layers: the underlayer 60, the seed layer 61, the antiferromagnetic layer 62, the first magnetic layer 63, the second magnetic layer 65, the nonmagnetic interlayer 64, and the protective layer 66. The first magnetic layer 63 corresponds to the fixed magnetic layer 63 included in the first magnetoresistance element 23. The second magnetic layer 65 corresponds to the free magnetic layer 65 included in the first magnetoresistance element 23. As shown in Fig. 8, in the first fixed resistance element 24, the first magnetic layer 63 and the second magnetic layer 65 are sequentially stacked on the antiferromagnetic layer 62. The magnetization of each of the first magnetic layer 63 and the second magnetic layer 65 is fixed by the exchange coupling field (Hex) which is generated between each of the first magnetic layer 63 and the second magnetic layer 65 and the antiferromagnetic layer 62. Unlike the free magnetic layer 65 of the first magnetoresistance element 23, the magnetization of the second magnetic layer 65 does not vary due to the external magnetic field.

As shown in Fig. 8, by forming each layer of the fixed resistance element 24 using a material the same as that of a corresponding layer of the first magnetoresistance element 23, the element resistance of the first magnetoresistance element 23 and the fixed resistance element 24 can be made substantially the same. Consequently, the potential of the first output retrieving unit 25 in a non-magnetic field state can be suitably controlled so as to be a central potential. In addition, a difference between the temperature coefficients (TCRs) of the first magnetoresistance element 23 and the fixed resistance element 24 can be reduced, thereby reducing a variation in the central potential with respect to a temperature variation and, therefore, the operational stability can be improved. Note that it is more desirable that the thickness of each layer of the second resistance element 24 is the same as that of the corresponding layer of the first magnetoresistance element 23 in addition to the material.

Similarly, although not shown, the fixed resistance element 28 series-connected to the second magnetoresistance element 27 has material layers the same as those of the second magnetoresistance element 27. However, the order in which the material layers are stacked is different from that of the second magnetoresistance element 27.

In contrast, all of the resistance elements included in the second series circuit 34 are formed from fixed resistance elements. Since a magnetoresistance element is not included, the fixed resistance elements 31 and 32 incorporated in the integrated circuit 22 need not be formed of a material layer the same as that of the magnetoresistance element.

That is, if the resistance elements 31 and 32 are fixed resistance elements formed of the same material layers and having substantially the same element resistance, the resistance elements 31 and 32 may have any layer structure.

Accordingly, when the resistance elements 31 and 32 are formed, a wide variety of materials can be used, as compared with the fixed resistance element 24 included in the first series circuit 26 or the fixed resistance element 28 included in the third series circuit 30.

According to the present embodiment, the fixed resistance elements 31 and 32 are incorporated in the integrated circuit 22. Unlike a magnetoresistance element, the fixed resistance elements 31 and 32 do not detect an external magnetic field. In the present embodiment, the fixed resistance elements 31 and 32 are provided to use the central potential of the second series circuit 34 as a reference potential for the first bridge circuit BC3 and the second bridge circuit BC4. Therefore, the fixed resistance elements 31 and 32 can be incorporated in the integrated circuit 22 without any problem.

In addition, according to the present embodiment, like other resistance elements provided in the integrated circuit 22, the fixed resistance elements 31 and 32 can be formed from silicon (Si), which has a significantly high resistance. The element resistance of the fixed resistance elements 31 and 32 can be increased to several tens of kΩ.

The cross-sectional shape of the magnetic detector 20 according to the present embodiment is described next with reference to Fig. 6. As shown in Fig. 6, in the magnetic detector 20, an underlayer made of silica (SiO₂) (not shown) and having a predetermined thickness is formed on a substrate 70 made of, for example, silicon (Si).

Active elements 71 to 73, such as a differential amplifier and a comparator, the third resistance element 31, the fourth resistance element 32, and an interconnection layer 77 of the integrated circuit 22 are formed on the underlayer. The interconnection layer 77 is formed of, for example, aluminum (Al).

As shown in Fig. 6, upper surfaces of the substrate 70 and the integrated circuit 22 are covered with an insulating layer 78 formed of a resist layer or the like. The insulating layer 78 has a hole portion 78b formed therein over a certain area of the interconnection layer 77, and the upper surface of the interconnection layer 78 is exposed through the hole portion 78b.

A surface 78a of the insulating layer 78 is formed from a planarized surface. The first resistance element 23, the second resistance element 24, the fifth resistance element 27, and the sixth resistance element 28 are formed on the planarized surface 78a of the insulating layer 78 in a meandering shape, as shown in Fig. 5. Accordingly, the element resistance of each of the elements can be increased.

As shown in Fig. 5, electrodes 23a, 23b, 24a, 24b, 27a, 27b, 28a, and 28b are formed on both ends of each of the elements. The electrode 23b of the first resistance element 23 is connected to the electrode 24b of the second resistance element 24 via the first output retrieving unit 25. As shown in Fig. 6, the first output retrieving unit 25 is electrically connected onto the interconnection layer 77. Similarly, the electrode 27b of the fifth resistance element 27 is connected to the electrode 28b of the sixth resistance element 28 via the third output retrieving unit 29. The third output retrieving unit 29 is electrically connected to the interconnection layer (not shown).

As shown in Fig. 6, the upper surfaces of the elements, the electrodes, and the output retrieving units are covered with the insulating layer 80 formed of, for example, alumina or silica. The magnetic detector 20 is packaged by a mold resin 81.

According to the present embodiment, as shown in Fig. 6, the integrated circuit 22 and the sensor unit 21 are stacked on the substrate 70 via the insulating layer 78 and, therefore, a large space of the upper surface 78a of the insulating layer 78 can be used as a space for forming the sensor unit 21. Consequently, a large space for forming each of the resistance elements 23, 24, 27, and 28 can be provided. When, as shown in Fig. 5, each of the resistance elements 23, 24, 27, and 28 is formed in the meandering shape, the length of each of the elements can be increased and, therefore, the element resistance of each of the resistance elements can be increased.

In particular, according to the present embodiment, since the third resistance element 31 and the fourth resistance element 32 included in the second series circuit 34 are incorporated in the integrated circuit 22, the number of elements included in the sensor unit 21 can be decreased. In addition, the space for forming resistance elements 23, 24, 27, and 28 included in the sensor unit 21 can be increased.

In addition, according to the present embodiment, the second series circuit 34 serves as a common circuit shared by the first bridge circuit BC3 and the second bridge circuit BC4. The central potential of the second series circuit 34 is used as the reference potential by the first bridge circuit BC3 and the second bridge circuit BC4.

Existing NS detection sensors using a magnetoresistance element require at least eight elements. However, according to the present embodiment, the magnetic detector having such a configuration can be formed from six elements in total, as shown in Figs. 1 and 2, thereby decreasing the number of elements. In existing NS detection sensors, in order to form the sensor unit 21, all of the eight elements need to be formed on the upper surface 78a of the insulating layer 78, as shown in Fig. 6. However, according to the present embodiment, as described above, the second series circuit 34 can be incorporated in the integrated circuit 22. In addition, the total number of elements forming the sensor unit 21 can be decreased. Despite the decrease in size of the magnetic detector 20, the space for forming the resistance elements 23, 24, 27, and 28 can be increased, as compared with existing NS detection sensors.

The principal of detection of an external magnetic field is described next.

First, the case where no external magnetic fields act on the magnetic detector 20 according to the present embodiment is described. In such a case, the resistance values of the first magnetoresistance element 23 and the second magnetoresistance element 27 stay unchanged. When the first switch circuit 36, the second switch circuit 43, and the third switch circuit 48 receive a clock signal from the clock circuit 53, the magnetic detector 20 is switched between the following two modes at every several tens of µsec: a circuit mode for detecting an external magnetic field (+H) in the positive direction and a circuit mode for detecting an external magnetic field (-H) in the negative direction. As shown in Fig. 1, in the circuit mode for detecting an external magnetic field (+H) in the positive direction, the first switch circuit 36 connects the first output retrieving unit 25 of the first series circuit 26 to the differential amplifier 35, the second switch circuit 43 connects the comparator 38 to the first external output terminal 40, and the third switch circuit 48 connects the first series circuit 26 to the ground terminal 42. As shown in Fig. 2, in the circuit mode for detecting an external magnetic field (-H) in the negative direction, the first switch circuit 36 connects the third output retrieving unit 29 of the third series circuit 30 to the differential amplifier 35, the second switch circuit 43 connects the comparator 38 to the second external output terminal 41, and the third switch circuit 48 connects the third series circuit 30 to the ground terminal 42.

When no external magnetic fields act on the magnetic detector 20, a differential potential between the first output retrieving unit 25 and the second output retrieving unit 33 of the first bridge circuit BC3 becomes substantially zero in the circuit mode for detecting an external magnetic field (+H) in the positive direction as shown in Fig. 1. In addition, in the circuit mode for detecting an external magnetic field (-H) in the negative direction as shown in Fig. 2, a differential potential between the third output retrieving unit 29 and the second output retrieving unit 33 of the second bridge circuit BC4 becomes substantially zero. When a differential potential of zero is output from the differential amplifier 35 to the comparator 38, the comparator 38 is controlled so that, for example, a high-level signal is output from the first external output terminal 40 and the second external output terminal 41 via the latch circuits 46 and 47, and the FET circuit 54 in accordance with the Schmidt trigger input.

Next, when an external magnetic field (+H) in the positive direction acts on the magnetic detector 20 according to the present embodiment, the resistance value of the first magnetoresistance element 23 varies. As a result, the potential of the first output retrieving unit 25 of the first series circuit 26 also varies from the central potential (for example, if the circuit configuration in Fig. 1 has the hysteresis characteristic shown in Fig. 3, the potential is increased).

In the circuit mode for detecting an external magnetic field (+H) in the positive direction as shown in Fig. 1, the central potential of the second output retrieving unit 33 of the second series circuit 34 is defined as a reference potential, and a differential potential between the first output retrieving unit 25 and the second output retrieving unit 33 of the first bridge circuit BC3 formed from the first series circuit 26 and the second series circuit 34 is generated using the differential amplifier 35. Thereafter, the generated differential potential is output to the comparator 38. The comparator 38 shapes the differential potential into a pulse signal by using the Schmidt trigger input. The shaped detection pulse signal is output from the first external output terminal 40 via the latch circuit 46 and the FET circuit 54. At that time, if the magnitude of the external magnetic field (+H) in the positive direction is greater than or equal to a predetermined value, the detection signal is controlled so as to be output from the first external output terminal 40 as a low-level signal. However, if the magnitude of the external magnetic field (+H) in the positive direction is less than the predetermined value, the comparator 38 is controlled so as to generate a high-level signal, as in the case where no external magnetic fields act on the magnetic detector 20.

In contrast, in the case where an external magnetic field (+H) in the positive direction acts on the magnetic detector 20, even when the mode is switched to the circuit mode for detecting an external magnetic field (-H) in the negative direction as shown in Fig. 2, the resistance value of the second magnetoresistance element 27 does not vary. Therefore, as in the case where no external magnetic fields act on the magnetic detector 20, control is performed so that a high-level signal is output from the second external output terminal 41.

As described above, when an external magnetic field having the predetermined magnitude or more in the positive direction (+H) acts on the magnetic detector, the signal level of the first external output terminal 40 changes from a high level to a low level or from a low level to a high level. Therefore, it can be detected from the variation in the signal level that an external magnetic field (+H) having the predetermined magnitude or more in the positive direction acts on the magnetic detector 20.

In the same manner, when the external magnetic field (-H) in the negative direction acts on the magnetic detector 20 according to the present embodiment, the resistance value of the second magnetoresistance element 23 varies. As a result, the potential of the second output retrieving unit 29 of the third series circuit 30 varies from the central potential (more specifically, the potential is increased).

In the circuit mode for detecting an external magnetic field (-H) in the negative direction as shown in Fig. 2, the central potential of the second output retrieving unit 33 of the second series circuit 34 is defined as a reference potential, and the differential potential between the third output retrieving unit 29 and the second output retrieving unit 33 of the second bridge circuit BC4 formed from the third series circuit 30 and the second series circuit 34 is generated by the differential amplifier 35. Thereafter, the generated differential potential is output to the comparator 38. The comparator 38 changes the differential potential to shape into the pulse signal by using the Schmidt trigger input. The shaped detection pulse signal is output from the second external output terminal 41 via the latch circuit 46 and the FET circuit 54. At that time, if the magnitude of external magnetic field (-H) in the negative direction is greater than or equal to a predetermined value, the detection signal is controlled so as to be output from the second external output terminal 41 as a low-level signal. However, the magnitude of the external magnetic field (-H) in the negative direction is less than the predetermined value, the comparator 38 is controlled so as to generate a high-level signal, as in the case where no external magnetic field acts on the magnetic detector 20.

In contrast, in the case where an external magnetic field (-H) in the negative direction acts on the magnetic detector 20, even when the mode is switched to the circuit mode for detecting an external magnetic field (+H) in the positive direction as shown in Fig. 1, the resistance value of the first magnetoresistance element 23 does not vary. Therefore, as in the case where no external magnetic fields act on the magnetic detector 20, control is performed so that a high-level signal is output from the first external output terminal 40.

As described above, when an external magnetic field having the predetermined magnitude or more in the negative direction (-H) acts on the magnetic detector, the signal level of the second external output terminal 41 changes from a high level to a low level or from a low level to a high level. Therefore, due to the variation in the signal level, an external magnetic field having the predetermined magnitude or more in the negative direction and acting on the magnetic detector 20 can be detected.

The detection signal output from the first external output terminal 40 or the second external output terminal 41 is used by a processing circuit of an apparatus (not shown). For example, the detection signal is used for an open/closed detection signal indicating whether a flip cell phone (described in more detail below) is opened or closed.

According to the present embodiment, the magnetic detector 20 is characterized in that the resistance elements of the second series circuit 34 connected in parallel to the first series circuit 26 including the first magnetoresistance element 23 and the third series circuit 30 including the second magnetoresistance element 27 are formed from the fixed resistance elements 31 and 32, and the element resistances of the fixed resistance elements 31 and 32 are greater than those of the resistance elements 23, 24, 27, and 28 included in the sensor unit 21.

According to the present embodiment, a magnetoresistance element is not included in the resistance elements of the second series circuit 34. Only the fixed resistance elements 31 and 32 are included in the second series circuit 34. Accordingly, unlike the fixed resistance element 24 included in the first series circuit 26 and the fixed resistance element 28 included in the third series circuit 30, which are series-connected to the magnetoresistance elements, the second series circuit 34 need not be formed from the material layers the same as those of the magnetoresistance element in order to suitably control the central potential.

Accordingly, the materials for the fixed resistance elements 31 and 32 can be selected from a wide variety of materials. In addition, the element resistances of the fixed resistance elements 31 and 32 can be made greater than those of the resistance elements 23, 24, 27, and 28 included in the first series circuit 26 and the second series circuit 30. Thus, a consumption current can be reduced.

According to the present embodiment, the fixed resistance elements 31 and 32 included in the second series circuit 34 are incorporated in the integrated circuit 22. In some embodiment, the fixed resistance elements 31 and 32 are incorporated in the sensor unit 21. However, by incorporating the fixed resistance elements 31 and 32 in the integrated circuit 22, the fixed resistance elements 31 and 32 can be formed of silicon (Si) having a significantly high sheet resistance in the same step as the other resistance elements of the integrated circuit 22 are formed. If the fixed resistance elements 31 and 32 are formed so as to have a meandering shape as shown in Fig. 5, the length of the element can be sufficiently long within a limited area, and therefore, the element resistance can be more effectively increased. However, even when such a space cannot be provided in the integrated circuit 22, the element resistance of the fixed resistance elements 31 and 32 can be effectively increased by forming the fixed resistance elements 31 and 32 using silicon (Si) having a high sheet resistance. As an example of the element resistance, the element resistance of the resistance elements 23, 24, 27, and 28 included in the sensor unit 21 ranges from about 2 kΩ to about 3 kΩ. However, the element resistance of the fixed resistance elements 31 and 32 included in the second series circuit 34 can be increased up to about 30 kΩ.

In addition, since the fixed resistance elements 31 and 32 are simply incorporated in the integrated circuit 22, the circuit configuration is not complicated. As will be described later, although the magnetic detector 20 according to the present embodiment is an NS detection sensor, the magnetic detector 20 requires only one differential amplifier 35 and only one comparator 38. Thus, the circuit configuration can be simplified, and a small circuit can be realized by using one integrated circuit 22.

The fixed resistance elements 31 and 32 incorporated in the integrated circuit 22 can be formed using a thin film forming process or a printing process, such as a CVD process or a sputtering process.

In order to suitably perform control so that the potential of the second output retrieving unit 33 of the second series circuit 34 is the central potential, it is desirable that the fixed resistance elements 31 and 32 are formed from the same material layer. In addition, by forming the fixed resistance elements 31 and 32 using the same material layer, a difference between the temperature coefficients (TCRs) can be reduced. Consequently, a variation in the central potential caused by a variation in temperature can be reduced, thereby improving the operational stability.

According to the present embodiment, by incorporating the fixed resistance elements 31 and 32 in the integrated circuit 22, the number of elements included in the sensor unit 21 can be decreased. That is, since the total number of elements included in the sensor unit 21 is four as shown in Figs. 1, 2, 5, and 6, the space for forming each of the resistance elements included in the sensor unit 21 can be increased. In particular, according to the present embodiment, the integrated circuit 22 and the sensor unit 21 are stacked on the substrate 70 with the insulating layer 78 therebetween. In one embodiment, the integrated circuit 22 and the sensor unit 21 are planarly arranged on the surface to form the structure. However, by stacking the integrated circuit 22 and the sensor unit 21 on the substrate 70 with the insulating layer 78 therebetween, a wider area in the upper surface 78a of the insulating layer 78 can be used as the space for forming the sensor unit 21. In addition, the magnetic detector 20 according to the present embodiment is an NS detection sensor, and the second series circuit 34 is used as the common circuit of the first bridge circuit BC3 and the second bridge circuit BC4. Consequently, while existing NS detection sensors using a magnetoresistance element requires at least eight elements, the magnetic detector according to the present embodiment can be formed from six elements as shown in Figs. 1 and 2. Thus, the number of elements required can be reduced.

As described above, since the space for forming each of the elements included in the sensor unit 21 can be effectively increased, the element lengths of the resistance elements 23, 24, 27, and 28 included in the sensor unit 21 can be increased. Accordingly, the element resistance of the resistance elements 23, 24, 27, and 28 can be increased, as compared with those of existing detectors. If each of the resistance elements 23, 24, 27, and 28 is formed so as to have a meandering shape as shown in Fig. 5, the length of the element can be increased within the limited space for forming the element, thereby advantageously increasing the element resistance.

Furthermore, according to the present embodiment, the central potential of the second series circuit 34 including the fixed resistance element 31 series-connected to the fixed resistance element 32 is commonly used as the reference potential of the first bridge circuit BC3 and the second bridge circuit BC4. In addition, the first switch circuit 36 is provided that switches between the connection between the first output retrieving unit 25 of the first series circuit 26 included in the first bridge circuit BC3 and the differential amplifier 35 and the connection between the third output retrieving unit 29 of the third series circuit 30 included in the second bridge circuit BC4 and the differential amplifier 35.

As described above, if the first switch circuit 36 is provided, the following two detection modes can be alternately provided by simply providing one differential amplifier 35: a mode for detecting an external magnetic field in the positive direction in which the first bridge circuit BC3 is connected to the differential amplifier 35 (see Fig. 1) and a mode for detecting an external magnetic field in the negative direction in which the second bridge circuit BC4 is connected to the differential amplifier 35 (see Fig. 2). In this way, the differential potentials can be obtained from the first bridge circuit BC3 and the second bridge circuit BC4 via the differential amplifier 35 using a simplified configuration.

That is, in existing magnetic detectors (Fig. 17), a differential amplifier is provided to each of the bridge circuits. However, according to the present embodiment, the two bridge circuits BC3 and BC4 are connected to the common differential amplifier 35 via the first switch circuit 36. In addition, through a switching operation performed by the first switch circuit 36, the following two detection modes can be provided: a mode for detecting an external magnetic field in the positive direction in which the first bridge circuit BC3 is connected to the differential amplifier 35 (see Fig. 1) and a mode for detecting an external magnetic field in the negative direction in which the second bridge circuit BC4 is connected to the differential amplifier 35 (see Fig. 2). Consequently, even only one differential amplifier 35 is sufficient and, thus, the number of signal lines can be reduced. As a result, the circuit configuration can be simplified, and the circuit size can be reduced.

In addition, according to the present embodiment, the third switch circuit 48 is provided that switches between a connecting between the ground terminal 42 and the first series circuit 26 and a connecting between the ground terminal 42 and the third series circuit 30.

The third switch circuit 48 connects the first series circuit 26 to the ground terminal 42 when the first switch circuit 36 connects the first bridge circuit BC3 to the differential amplifier 35. In contrast, the third switch circuit 48 connects the second series circuit 30 to the ground terminal 42 when the first switch circuit 36 connects the second bridge circuit BC4 to the differential amplifier 35. Accordingly, an electric current does not flow in the second series circuit 30 when the first bridge circuit BC3 is connected to the differential amplifier 35, and an electric current does not flow in the first series circuit 26 when the second bridge circuit BC4 is connected to the differential amplifier 35. As a result, a consumption current can be reduced more effectively.

The usage of the magnetic detector 20 serving as an NS detection device according to the present embodiment is described next. For example, the magnetic detector 20 according to the present embodiment can be used for detecting the open and close state of a flip cell phone.

As shown in Fig. 9, the flip cell phone 90 includes a first member 91 and a second member 92. The first member 91 is a screen display portion, and the second member 92 is an operation portion. A surface of the first member 91 facing the second member 92 includes a liquid crystal display (LCD), a receiver or the like. A surface of the second member 92 facing the first member 91 includes a variety of types of button and a microphone. Fig. 9 illustrates the flip cell phone 90 in a closed state. As shown in Fig. 9, the first member 91 has a magnet 94 incorporated therein, and the second member 92 has the magnetic detector 20 according to the present embodiment incorporated therein. In the closed state as shown in Fig. 9, the magnet 94 and the magnetic detector 20 are located so as to face each other. Alternatively, the magnetic detector 20 may be disposed at a position shifted from the position facing the magnet 94 in a direction parallel to a direction in which the external magnetic field is applied.

In Fig. 9, the external magnetic field (+H) generated by the magnet 94 in the positive direction propagates to the magnetic detector 20. The external magnetic field (+H) is detected by the magnetic detection device 20. Thus, the closed state of the flip cell phone 90 is detected.

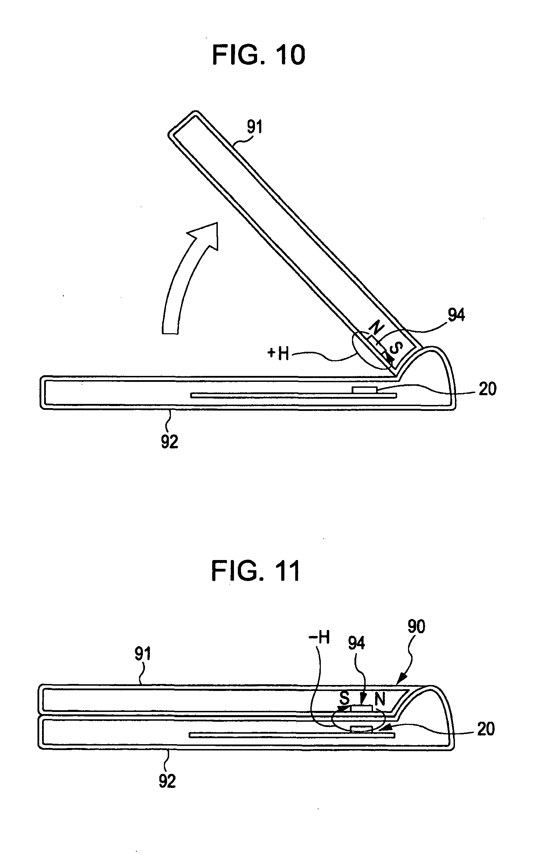

When, as shown in Fig. 10, the flip cell phone 90 is open and as the first member 91 moves away from the second member 92, the magnitude of the external magnetic field (+H) applied to the magnetic detector 20 decreases. Finally, the magnitude of the external magnetic field (+H) applied to the magnetic detector 20 becomes zero. When the magnitude of the external magnetic field (+H) applied to the magnetic detection device 20 is less than or equal to a predetermined value, the open state of the flip cell phone 90 is detected. For example, at that time, a control unit included in the flip cell phone 90 performs control so that a backlight source provided on a rear side of the liquid crystal display or the operation buttons emits light.

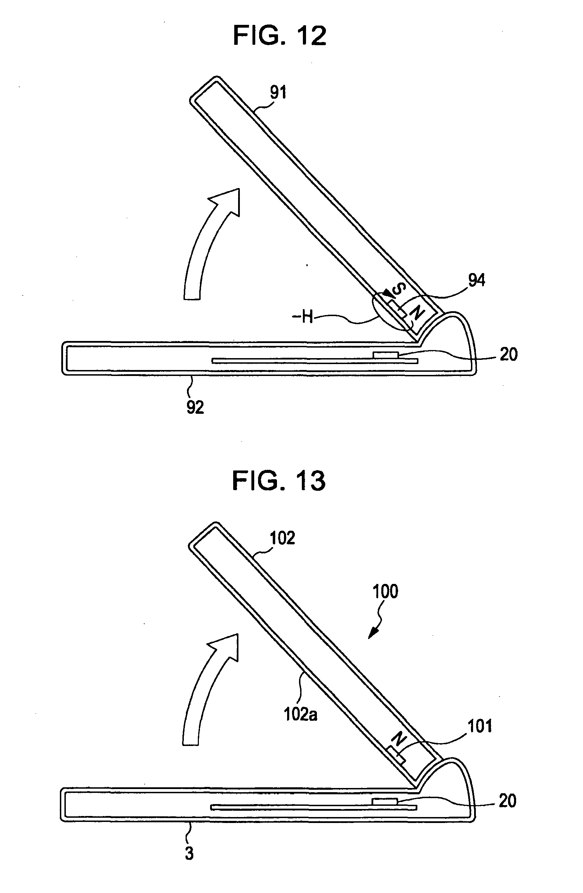

The magnetic detector 20 of the present embodiment is an NS detection sensor. That is, in Fig. 9, an N pole of the magnet 94 is disposed on the left side of the drawing and an S pole is disposed on the right side of the drawing. However, as shown in Fig. 11, when the polarities are reversed (the N pole is disposed on the right side of the drawing, and the S pole is disposed on the left side), the direction in which the external magnetic field (-H) is applied to the magnetic detector 20 (hereinafter referred to as a "negative direction") is opposite to the direction of the external magnetic field (+H) shown in Fig. 1 is applied. According to the present embodiment, even in such a case, an open state of the flip cell phone 90 can be properly detected when the closed state of the cellular phone 90 as shown in Fig. 11 is changed to the open state as shown in Fig. 12.

Accordingly, since the magnet 94 can be disposed at any location regardless of the polarities of the external magnetic fields, the assembly of the flip cell phone is facilitated.

In the above-described method for detecting the open state and closed state of the flip cell phone, the magnetic detector need not detect the direction of the external magnetic field. Only detection of a variation in the external magnetic field using the two poles is needed. Accordingly, for example, the magnetic detector 20 may be configured by using one of the external output terminals 40 and 41 shown in Figs. 1 and 2.

That is, for instance, by removing the second switch circuit 43 shown in Figs. 1 and 2 and forming a signal line that extends from the comparator 38 to the external output terminal 40 via the latch circuit 46 and the FET circuit 54 from the comparator 38, a detection signal of the external magnetic field in the positive direction (+H) and a detection signal of the external magnetic field in the negative direction (-H) can be obtained from the external output terminal 40. At that time, since the two detection signals are low-level signals as mentioned above, which signal is for the positive direction or the negative direction of the external magnetic field cannot be detected. However, in detecting the open/closed state, the direction of an external magnetic field is not always required. Therefore, the circuit configuration may be further simplified by providing only one external output terminal.

In contrast, as in the case of a turn over type flip cell phone 100 described below, in order to start different functions in accordance with the direction of the external magnetic field, it is desirable to provide the two external output terminals 40 and 41, as shown in Figs. 1 and 2, so that the direction of the external magnetic field can be detected.

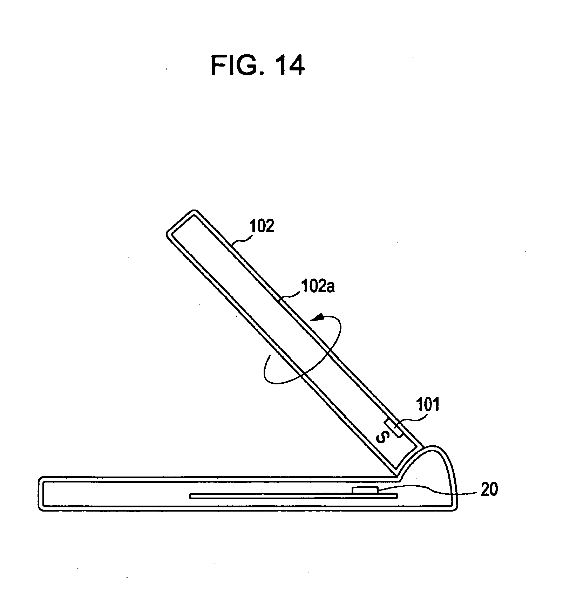

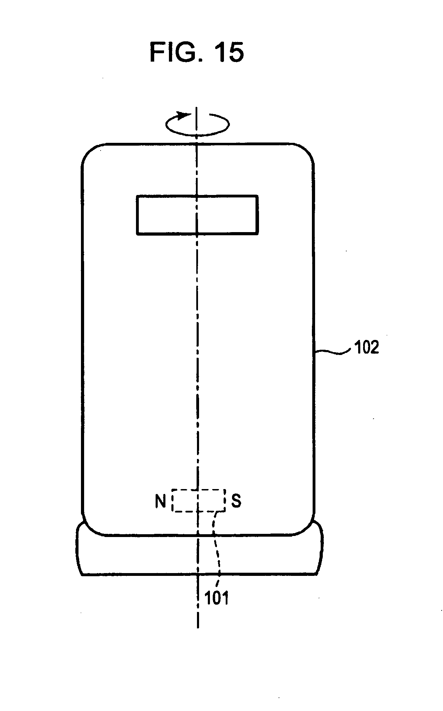

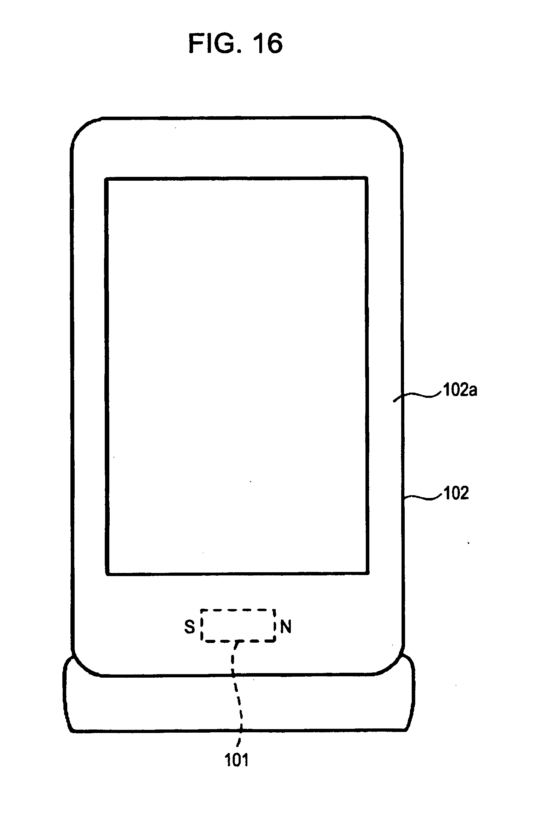

When the flip cell phone 100 is opened as shown Fig. 13, the open state of the flip cell phone 100 is detected using variation in the magnitude of the external magnetic field applied to the magnetic detector 20, as illustrated in Figs. 10 and 12. The position of a magnet 101 in Fig. 13 is the same as that shown by the plan view in Fig. 15. The first member 102 of the flip cell phone 100 is rotated about a rotation axis by 180 degrees, so that the screen display surface 102a serving as the inner surface of the first member 102 in the state shown in Fig. 13 is turned so as to face the outside as shown in Figs. 14 and 16. At that time, as shown in Fig. 16, the direction of the magnet 101 is reversed from that shown in Fig. 15. For example, when a camera function is started by turning over the first member 102, the magnetic detector 20 needs to detect that the direction of the magnet 101 is reversed in addition to detecting the open or closed state of the flip cell phone 100, as shown in Fig. 13. According to the present embodiment, by providing the circuit configuration including the two output terminals 40 and 41 shown in Figs. 1 and 2, the magnetic detector 20 can detect whether the signal is a signal indicating detection of the external magnetic field (+H) in the positive direction or a signal indicating detection of the external magnetic field (-H) in the negative direction.

The element configuration of the sensor unit 21 according to the present embodiment is only illustrative. Any other element configuration may be employed. For example, the present embodiment has been described with reference to the case in which the second resistance element 24 connected to the first series circuit 26 and the sixth resistance element 28 connected to the third series circuit 30 shown in Figs. 1 and 2 are fixed resistance elements that have a resistance value that does not vary in accordance with the external magnetic field. However, the second resistance element 24 may be formed from a magnetoresistance element having an electrical resistance value that changes in accordance with the magnitude of the external magnetic field (+H) in the positive direction and that increases or decreases in a manner opposite to that of the first magnetoresistance element 23. In addition, the sixth resistance element 28 may be formed from a magnetoresistance element having an electrical resistance value that changes in accordance with the magnitude of the external magnetic field (-H) in the negative direction and that increases or decreases in a manner opposite to that of the second magnetoresistance element 27. Such a configuration can advantageously increase a differential potential and, therefore, the detection sensitivity can be improved.

Moreover, it is selectable whether or not to apply a bias magnetic field to the magnetoresistance element. It is not necessary to apply the bias magnetic field to the free magnetic layer included in the magnetoresistance element. However, if the bias magnetic field is applied to the free magnetic layer, for example, the magnetizations of the fixed magnetic layer and the free magnetic layer are controlled so as to be orthogonal to each other in a state in which no external magnetic field is applied.

Furthermore, the magnetic detector 20 according to the present embodiment may be used to detect the open and closed state of mobile electronic devices, such as a game machine, in addition to detecting the opening and closed state of flip cell phones. The present embodiment is also applicable to the case in which the magnetic detector 20 of an NS type is required in addition to the case in which the open and closed state is detected as described above.

### Brief Description of Drawings

[Fig. 1] Fig. 1 is a circuit diagram illustrating a circuit state of a magnetic detector when the magnetic detector detects an external magnetic field in a positive direction, according to the present embodiment.
[Fig. 2] Fig. 2 is a circuit diagram illustrating a circuit state of the magnetic detector when the magnetic detector detects an external magnetic field in a negative direction, according to the present embodiment.
[Fig. 3] Fig. 3 is a graph (an R-H curve) illustrating a hysteresis characteristic of a first magnetoresistance element.
[Fig. 4] Fig. 4 is a graph (an R-H curve) illustrating a hysteresis characteristic of a second magnetoresistance element.
[Fig. 5] Fig. 5 is a partial enlarged perspective view of a magnetic detector 20, in which a shape of a resistance element of a sensor unit of the magnetic detector according to the present embodiment is illustrated.
[Fig. 6] Fig. 6 is a partial cross-sectional view of the magnetic detector taken along line A-A of Fig. 5 in the thickness direction as viewed in the direction indicated by an arrow.
[Fig. 7] Fig. 7 is a partial cross-sectional view illustrating the layer structures of the first magnetoresistance and the second magnetoresistance elements.
[Fig. 8] Fig. 8 is a partial cross-sectional view mainly illustrating the layer structure of a fixed resistance element.
[Fig. 9] Fig. 9 illustrates an example of usage of the magnetic detector according to the present embodiment (a partial view schematically illustrating a flip cell phone including the magnetic detector when the flip cell phone is closed).
[Fig. 10] Fig. 10 illustrates an example of usage of the magnetic detector according to the embodiment (a partial view schematically illustrating a flip cell phone including the magnetic detector when the flip cell phone is open).
[Fig. 11] Fig. 11 illustrates an example of usage of the magnetic detector according to the embodiment (a partial view schematically illustrating a flip cell phone including the magnetic detector when a magnet is disposed in a direction opposite to that of Fig. 9 and the flip cell phone is closed).
[Fig. 12] Fig. 12 illustrates an example of usage of the magnetic detector according to the embodiment (a partial view schematically illustrating a flip cell phone including the magnetic detector when a magnet is disposed in a direction opposite to that of Fig. 10 and the flip cell phone is open).
[Fig. 13] Fig. 13 illustrates an example of usage of the magnetic detector according to the embodiment (a partial view schematically illustrating a flip cell phone including the magnetic detector when the flip cell phone is open).
[Fig. 14] Fig. 14 illustrates an example of usage of the magnetic detector according to the embodiment (a partial view schematically illustrating a flip cell phone including the magnetic detector when a first member is turned over).
[Fig. 15] Fig. 15 illustrates an example of usage of the magnetic detector according to the embodiment (a partial plan view of a flip cell phone including the magnetic detector illustrated in Fig. 13).
[Fig. 16] Fig. 16 illustrates an example of usage of the magnetic detector according to the embodiment (a partial plan view of a flip cell phone including the magnetic detector illustrated in Fig. 15).
[Fig. 17] Fig. 17 is a circuit diagram illustrating an existing magnetic detector.

### Reference Numerals

20 magnetic detector
21 sensor unit
22 integrated circuit (IC)
23 first magnetoresistance element (first resistance element)
24 fixed resistance element (second resistance element)
25 first output retrieving unit
26 first series circuit
27 second magnetoresistance element (fifth resistance element)
28 fixed resistance element (sixth resistance element)
29 third output retrieving unit
30 third series circuit
31 fixed resistance element (third resistance element)
32 fixed resistance element (fourth resistance element)
33 second output retrieving unit
34 second series circuit
35 differential amplifier
36 first switch circuit (first connection switching unit)
38 comparator
39 input terminal
40 first external output terminal
41 second external output terminal
42 ground terminal
43 second switch circuit
46, 47 latch circuit
48 third switch circuit
53 clock circuit
62 antiferromagnetic layer
63 fixed magnetic layer (first magnetic layer)
64 nonmagnetic interlayer
65, 67 free magnetic layer (second magnetic layer)
78, 80 insulating layer
81 mold resin
90, 100 flip cell phone
91, 102 first member
92 second member
94, 101 magnet

## Claims

1. A magnetic detector (20) comprising:
a bridge circuit including a first series circuit (26) connected between a power supply (39) and a ground terminal (42) and a second series circuit (34) connected between the power supply (39) and the ground terminal (42) in parallel to the first series circuit (26);
**characterized in that**
the first series circuit (26) includes a plurality of serially connected resistance elements (23, 24), and at least one of the resistance elements (23, 24) is a magnetoresistance element (23) having an electric resistance that changes in accordance with an external magnetic field using a magnetoresistance effect, and
the second series circuit (34) includes a plurality of serially connected resistance elements (31, 32), and all of the resistance elements (31, 32) are fixed resistance elements (32, 32) having an electric resistance that does not change in accordance with an external magnetic field, and
an element resistance of the fixed resistance elements (31, 32) included in the second series (34) circuit is greater than an element resistance of the resistance elements (23) included in the first series circuit (26).

2. The magnetic detector (20) according to Claim 1, further comprising:
a sensor unit (21) disposed on a substrate (70), the sensor unit (21) including the first series circuit (26); and
an integrated circuit (22) disposed on the substrate (70), the integrated circuit being connected to the sensor unit (21), the integrated circuit (22) outputting a magnetic field detection signal; wherein the second series (34) circuit is incorporated in the integrated circuit (22).

3. The magnetic detector (20) according to Claim 1, further comprising:
a third series circuit (30) connected between the power supply (39) and the ground terminal (42) in parallel to the first and second series circuits (26, 34) and including a plurality of serially connected resistance elements (27, 28);
wherein the magnetoresistance element (23) included in the first series circuit (26) has an electric resistance that changes in accordance with variation in the magnitude of an external magnetic field in a certain direction using a magnetoresistance effect, and
wherein at least one of the plurality of resistance elements (27, 28) included in the third series circuit (30) is a magnetoresistance element (27) having an electric resistance that changes in accordance with an external magnetic field in a direction opposite to the certain direction, and
wherein the first series circuit (26) is connected to the second series circuit (34) in parallel so as to form the first bridge circuit that detects the external magnetic field in the certain direction, and the second series circuit (34) is connected to the third series circuit (30) in parallel so as to form a second bridge circuit that detects the external magnetic field in the direction opposite to the certain direction.

4. The magnetic detector (20) according to Claim 3, wherein the plurality of resistance elements(27, 28) included in the third series circuit (30) are formed from the same material layers.

5. The magnetic detector (20) according to Claim 3 or 4, further comprising:
a sensor unit (21) disposed on a substrate (70), the sensor unit (21) including the first series circuit (26) and the third series circuit (30); and
an integrated circuit (22) disposed on the substrate (70), the integrated circuit (22) being connected to the sensor unit (21), the integrated circuit (22) outputting a magnetic field detection signal; wherein the second series circuit (34) is incorporated in the integrated circuit (22).

6. The magnetic detector (20) according to Claim 2 or 5, wherein the integrated circuit (22) is formed on the substrate (70), and the sensor unit (21) is formed on the integrated circuit (22) with an insulating layer (78) therebetween.

7. The magnetic detector (20) according to any one of Claims 1 to 6, wherein the plurality of resistance elements (23, 24) included in the first series circuit (26) are formed from the same material layers.

8. The magnetic detector (20) according to any one of Claims 1 to 7, wherein the plurality of fixed resistance elements (31, 32) included in the second series circuit (34) are formed from the same material layers.

9. The magnetic detector (20) according to Claim 8, wherein the fixed resistance elements (31, 32) are formed of silicon (Si).

## Patentansprüche

1. Magnetdetektor (20) aufweisend:
eine Brückenschaltung mit einer ersten Reihenschaltung (26), die zwischen einer Energieversorgung (39) und einem Masseanschluss (42) angeschlossen ist, und einer zweiten Reihenschaltung (34), die parallel zu der ersten Reihenschaltung (26) zwischen der Energieversorgung (39) und dem Masseanschluss (42) angeschlossen ist;
**dadurch gekennzeichnet, dass**
die erste Reihenschaltung (26) mehrere in Reihe miteinander verbundene Widerstandelemente (23, 24) umfasst, und wenigstens eines der Widerstandselemente (23, 24) ein Magnetwiderstandselement (23) mit einem elektrischen Widerstand ist, der sich unter Ausnutzung eines Magnetwiderstandseffektes einem äußeren Magnetfeld entsprechend ändert, und
die zweite Reihenschaltung (34) mehrere in Reihe miteinander verbundene Widerstandselemente (31, 32) umfasst und alle Widerstandselemente (31, 32) Festwiderstandselemente (31, 32) sind, die einen elektrischen Widerstand haben, der sich nicht einem äußeren Magnetfeld entsprechend ändert, und
ein Elementwiderstand der Festwiderstandselemente (31, 32), die in der zweiten Reihenschaltung (34) enthalten sind, größer ist, als ein Elementwiderstand der Widerstandselemente (23), die in der ersten Reihenschaltung (26) enthalten sind.

2. Magnetdetektor (20) nach Anspruch 1, zusätzlich aufweisend:
eine Sensoreinheit (21), die auf einem Substrat (70) angeordnet ist, wobei die Sensoreinheit (21) die erste Reihenschaltung (26) enthält; und
eine integrierte Schaltung (23), die auf dem Substrat (70) angeordnet ist, wobei die integrierte Schaltung mit der Sensoreinheit (21) verbunden ist und die integrierte Schaltung (22) ein Magnetfeld-Detektions-signal ausgibt, wobei die zweite Reihenschaltung (34) in der integrierten Schaltung (22) enthalten ist.

3. Magnetdetektor (20) nach Anspruch 1, zusätzlich aufweisend:
eine dritte Reihenschaltung (30), die parallel zur ersten und zweiten Reihenschaltung (26, 34) zwischen der Energieversorgung (39) und dem Masseanschluss (42) angeschlossen ist, und mehrere in Reihe miteinander verbundene Widerstandselemente (27, 28) aufweist; wobei das in der ersten Reihenschaltung (26) enthaltene Magnetwiderstandselement (23) einen elektrischen Widerstand hat, der sich unter Ausnutzung eines Magnetwiderstandseffektes einer Änderung der Größe eines äußeren Magnetfeldes in einer bestimmten Richtung entsprechend ändert, und
wobei wenigstens eines der mehreren Widerstandselemente (27, 28), das in der dritten Reihenschaltung (30) enthalten ist, ein Magnetwiderstandselement (27) mit einem elektrischen Widerstand ist, der sich einem äußeren Magnetfeld in einer Richtung, die der bestimmten Richtung entgegengesetzt ist, entsprechend ändert, und
wobei die erste Reihenschaltung (26) parallel so mit der zweiten Reihenschaltung (34) verbunden ist, dass sie eine erste Brückenschaltung bilden, die das äußere Magnetfeld in der bestimmten Richtung detektiert, und wobei die zweite Reihenschaltung (34) parallel so mit der dritten Reihenschaltung (30) verbunden ist, dass sie eine zweite Brückenschaltung bilden, die das äußere Magnetfeld in der Richtung detektiert, die der bestimmten Richtung entgegengesetzt ist.

4. Magnetdetektor (20) nach Anspruch 3, wobei die mehreren Widerstandselemente (27, 28), die in der dritten Reihenschaltung (30) enthalten sind, aus den gleichen Materialschichten ausgebildet sind.

5. Magnetdetektor (20) nach Anspruch 3 oder 4, zusätzlich aufweisend:
eine Sensoreinheit (22), die auf einem Substrat (70) angeordnet ist, wobei die Sensoreinheit (21) die erste Reihenschaltung (26) und die dritte Reihenschaltung (30) enthält; und
eine integrierte Schaltung (22), die auf dem Substrat (70) angeordnet ist, wobei die integrierte Schaltung (22) mit der Sensoreinheit (21) verbunden ist, und die integrierte Schaltung (22) ein Magnetfelderkennungssignal ausgibt, wobei die zweite Reihenschaltung (34) in der integrierte Schaltung (22) enthalten ist.

6. Magnetdetektor (20) nach Anspruch 2 oder 5, wobei die integrierte Schaltung (22) auf dem Substrat (70) ausgebildet ist, und die Sensoreinheit (21) auf der integrierten Schaltung (22) mit einer isolierenden Schicht (28) dazwischen ausgebildet ist.

7. Magnetdetektor (20) nach einem der Ansprüche 1 bis 6, wobei die mehreren Widerstandselemente (23, 24), die in der ersten Reihenschaltung (26) enthalten sind, aus den gleichen Materialschichten ausgebildet sind.

8. Magnetdetektor (20) nach einem der Ansprüche 1 bis 7, wobei die mehreren Festwiderstandselemente (31, 32), die in der zweiten Reihenschaltung (34) enthalten sind, aus den gleichen Materialschichten ausgebildet sind.

9. Magnetdetektor (20) nach Anspruch 8, wobei die Festwiderstandselemente (31, 32) aus Silicium (Si) ausgebildet sind.

## Revendications

1. Détecteur magnétique (20) comprenant :
un circuit en pont comprenant un premier circuit série (26) connecté entre une alimentation électrique (39) et une borne de masse (42) et un deuxième circuit série (34) connecté entre l'alimentation (39) et la borne de masse (42) parallèlement au premier circuit série (26) ;
**caractérisé en ce que** :
le premier circuit série (26) comprend une pluralité d'éléments de résistance montés en série (23, 24), et au moins l'un des éléments de résistance (23, 24) est un élément à magnétorésistance (23) ayant une résistance électrique qui change en fonction d'un champ magnétique extérieur en utilisant un effet de magnétorésistance, et
le deuxième circuit série (34) comprend une pluralité d'éléments de résistance montés en série (31, 32), et tous ces éléments de résistance (31, 32) sont des éléments à résistance fixe (32, 32) ayant une résistance électrique qui ne change pas en fonction d'un champ magnétique extérieur, et
une résistance d'élément des éléments à résistance fixe (31, 32) inclus dans le deuxième circuit série (34) est supérieure à une résistance d'élément des éléments de résistance (23) inclus dans le premier circuit série (26).

2. Détecteur magnétique (20) selon la revendication 1, comprenant en outre :
une unité de capteur (21) disposée sur un substrat (70), l'unité de capteur (21) comprenant le premier circuit série (26) ; et
un circuit intégré (22) disposé sur le substrat (70), le circuit intégré étant connecté à l'unité de capteur (21), le circuit intégré (22) délivrant un signal de détection de champ magnétique ; dans lequel le deuxième circuit série (34) est incorporé dans le circuit intégré (22).

3. Détecteur magnétique (20) selon la revendication 1, comprenant en outre :
un troisième circuit série (30) connecté entre l'alimentation (39) et la borne de masse (42) parallèlement aux premier et deuxième circuits série (26, 34) et comprenant une pluralité d'éléments de résistance montés en série (27, 28) ;
dans lequel l'élément à magnétorésistance (23) inclus dans le premier circuit série (26) a une résistance électrique qui change en fonction de la variation d'amplitude d'un champ magnétique extérieur dans une certaine direction en utilisant un effet de magnétorésistance, et
dans lequel au moins l'un des éléments de résistance (27, 28) inclus dans le troisième circuit série (30) est un élément à magnétorésistance (27) ayant une résistance électrique qui change en fonction d'un champ magnétique extérieur dans une direction opposée à ladite certaine direction, et
dans lequel le premier circuit série (26) est connecté au deuxième circuit série (34) en parallèle afin de former le premier circuit en pont qui détecte le champ magnétique extérieur dans ladite certaine direction, et le deuxième circuit série (34) est connecté au troisième circuit série (30) en parallèle afin de former un deuxième circuit en pont qui détecte le champ magnétique extérieur dans la direction opposée à ladite certaine direction.

4. Détecteur magnétique (20) selon la revendication 3, dans lequel les éléments de résistance (27, 28) inclus dans le troisième circuit série (30) sont formés à partir des mêmes couches de matériau.

5. Détecteur magnétique (20) selon la revendication 3 ou 4, comprenant en outre :
une unité de capteur (21) disposée sur un substrat (70), l'unité de capteur (21) comprenant le premier circuit série (26) et le troisième circuit série (30) ; et
un circuit intégré (22) disposé sur le substrat (70), le circuit intégré (22) étant connecté à l'unité de capteur (21), le circuit intégré (22) délivrant un signal de détection de champ magnétique ; dans lequel le deuxième circuit série (34) est incorporé dans le circuit intégré (22).

6. Détecteur magnétique (20) selon la revendication 2 ou 5, dans lequel le circuit intégré (22) est formé sur le substrat (70), et l'unité de capteur (21) est formée sur le circuit intégré (22) avec une couche isolante (78) entre eux.

7. Détecteur magnétique (20) selon l'une quelconque des revendications 1 à 6, dans lequel tous les éléments de résistance (23, 24) inclus dans le premier circuit série (26) sont formés à partir des mêmes couches de matériau.

8. Détecteur magnétique (20) selon l'une quelconque des revendications 1 à 7, dans lequel tous les éléments à résistance fixe (31, 32) inclus dans le deuxième circuit série (34) sont formés à partir des mêmes couches de matériau.

9. Détecteur magnétique (20) selon la revendication 8, dans lequel les éléments à résistance fixe (31, 32) sont en silicium (Si).
